# EUROPEAN PATENT SPECIFICATION

(11) **EP 2 844 419 B1**
(45) Date of publication and mention of the grant of the patent: **12.09.2018**
(21) Application number: 13780717.8
(22) Date of filing: 25.04.2013
(51) Int. Cl.: B29C 65/08, B29C 65/16, B29C 65/72, B29C 65/78, B29C 59/16, B29L 9/00, B81C 1/00, B81C 3/00, B23K 26/60, B23K 26/324, B23K 26/244, B23K 103/00

(54) **LASER JOINING METHODS**
LASERFÜGEVERFAHREN
METHODES D'ASSEMBLAGE AU LASER

(30) Priority: 26.04.2012 US 201261638850 P
(43) Date of publication of application: 11.03.2015
(73) Proprietor: Alere San Diego, Inc., San Diego, CA 92121 (US)
(72) Inventor: OLSSON, Erik, Mikael, San Diego, CA 92130 (US); RIVERON, Jonathan, San Diego, CA 92117 (US); TOVAR, Armando, Raul, San Diego, CA 92122 (US)
(74) Representative: Lee, Nicholas John
(86) International application number: PCT/US2013/038223
(87) International publication number: WO 2013/163433

(56) References cited:
- WO-A1-2009/125997
- WO-A1-2011/039238
- WO-A1-2012/000106
- WO-A2-2008/025351
- JP-A- S6 255 121
- US-A- 4 330 699
- US-A- 6 001 201
- US-A1- 2010 102 664

## Description

### FIELD OF THE INVENTION

The present invention relates to methods for joining materials.

### BACKGROUND OF THE INVENTION

The manufacture and assembly of many articles typically involves the joining or bonding of two surfaces together to form a composite. Within the realm of microfluidic devices, methods and means for joining parts dictate to some extent the nature of the fixing means that may be used. For example, processes for the manufacture of disposable test strips of the type which might be used to measure glucose, typically involve high speed processing of web-based substrates which may include use of printed adhesive or tape based adhesives. Often such adhesives are pressure activated, and the act of bringing two parts in contact may be sufficient to activate the adhesive.

Proposals to address the limitations associated with use of pressure sensitive adhesives in assembly of articles are described in the literature. US patent 3,477,194 describes a heat sealed thermoplastic package, which may be used to effect the continuous packaging of articles. US patent application 2004-0056006 (now abandoned) describes a method of forming a weld between workpieces. The method comprises: exposing the joint region (3) to incident radiation (4) having a wavelength outside the visible range so as to cause melting of the surface of one or both workpieces at the joint region, and allowing the melted material to cool thereby welding the workpieces together. A radiation absorbing material is provided at the joint region (3) in one of the workpieces (1,2) or between the workpieces which has an absorption band matched to the wavelength of the incident radiation so as to absorb the incident radiation and generate heat for the melting process. WO 2008/025351 discloses a method for the manufacture of a bioreactor or of a lab-on-a-chip system. The method involves joining a first body, made from a polymer which is at least partially transparent for electromagnetic radiation of at least one wavelength, to a second body, made from a ceramic material, which absorbs electromagnetic radiation of the at least one wavelength. The first and second bodies are contacted and electromagnetic radiation is used to melt a region of the first body in contact with the second body.
WO 2009/125997 discloses a method for fabricating a microfluidic circuit element. The method comprises joining a first substrate and a second substrate such that a groove is formed therebetween to serve as a microfluidic channel which has an inlet and an outlet for a sample to flow therethrough and nano interstices having a height which is less than that of the centre of the microfluidic channel formed at both sides of the microfluidic channel. To form the groove, the first and second substrates are joined using at least one joining process selected from the group consisting of processes using a solvent, ultrasonic radiation, an adhesive, a tape, heat, a laser beam, and pressure application. In particular, WO 2009/125997 discloses a process of joining only preformed protruded portions of a substrate to another substrate using ultrasonic radiation. JP S6255121 discloses a method of joining synthetic resin materials to each other. The method involves providing short fibers between synthetic resin materials laminated on each other. A laser is used to melt a portion of the resin and ultrasonic energy is applied which drives the fibers into the molten portion resulting in welding.

In accordance with the present invention, a method of forming a joint between workpieces is provided which may be achieved without requirement for additives or externally applied adhesives.

### SUMMARY OF THE INVENTION

The present invention relates to methods for joining materials.
In a first aspect, the invention provides a method of joining a first substrate to a second substrate, comprising;
(a) providing a structure on a first portion of a surface of the first substrate, which structure acts as an energy director;
(b) irradiating a second portion of the same surface of the first substrate with a laser having a first wavelength;
(c) contacting the patterned surface of the first substrate with a second substrate;
(d) applying ultrasonic radiation to a surface of the second substrate in proximity of the energy director on the first substrate;
(e) irradiating the previously irradiated portion of the first substrate that is in contact with the second substrate with a laser having a second wavelength, different to the first wavelength, optionally wherein the first substrate and second substrate are joined by laser welding in the absence of an externally applied force.
In a second aspect, the invention provides a method of joining a first substrate and a second substrate, comprising;
(a) disposing a first pattern on a surface of the first substrate, wherein such pattern may be formed by either
   (i) injection moulding, or
   (ii) hot embossing, or
   (iii) milling, or
   (iv) extruding, or
   (v) dispensing;
(b) disposing a second pattern on the surface of the first substrate, wherein such pattern may be formed by either
   (i) exposing the substrate to a laser with a first wavelength, or
   (ii) printing a pattern using a pigment composition, or
   (iii) scribing a line using a marker implement;
(c) contacting the patterned substrate with a second substrate;
(d) exposing the patterned first substrate in contact with the second substrate to ultrasonic energy in proximity of the first pattern, wherein the presence of the first pattern on the substrate absorbs ultrasonic energy, generating localised melting of the substrate, thereby joining the first and second substrate in the proximity of the first pattern;
(e) exposing the patterned substrate in contact with the second substrate to a laser beam having a second wavelength, different to the first wavelength, wherein the presence of the second pattern on the first substrate absorbs the second wavelength laser energy thereby heating and melting the first substrate in proximity of the second pattern, optionally wherein the first substrate and second substrate are joined by laser welding in the absence of an externally applied force.

Also disclosed herein is a method that includes increasing an absorbance of a portion of a first material to light having a second wavelength, contacting the portion of the first material with a portion of a second material; and irradiating the contacted portions of the first and second materials with light having the second wavelength and an intensity sufficient to join the first and second substrates at irradiated portions thereof.

Increasing the absorbance may include carbonizing at least a portion of the first material. Increasing the absorbance of at least a portion of the first material may be performed by, for example, irradiating the first material with light, e.g., with a laser beam, heating the first material, and/or applying a chemical substance to the first material. Increasing the absorbance may include irradiating the first material with light having a first wavelength, which may be different from the second wavelength. Irradiating the first material with light having the first wavelength may carbonize at least a portion of the first material.

Increasing the absorbance may include oxidizing at least a portion of the first material. Oxidizing at least a portion of the first material may be performed by, for example, irradiating the first material with light, e.g., with a laser beam, heating the first material, and/or applying a chemical to the first material. Increasing the absorbance may include irradiating the first material with light having a first wavelength, which may be different from the second wavelength. Irradiating the first material with light having the first wavelength may carbonize at least a portion of the first material. Oxidizing at least a portion of the first material may be performed as an alternative to, or in combination with, carbonizing at least a portion of the first material.

Increasing the absorbance may include applying an agent or coating to the surface of the first material. Such an agent or coating may not alter the chemical composition of the first material. However the presence of such an agent or coating renders the surface of the first material susceptible to light having a second wavelength, different to the first wavelength that may be used to directly increase the absorbance of the first material to such second wavelength.

Such additives may cause a change in the chemical composition of the first material which renders the first substrate susceptible to a second wavelength, which is different from a first wavelength used to modify the surface of the first substrate. In such case the additive may expose certain chemical groups on the surface of the first material, which chemical groups have an increased absorbance with respect to a second wavelength of light.

Increasing the absorbance may include applying an additive to the surface of the first material that absorbs light of the second wavelength. For example the additive may be applied by a process of printing, spraying, dip coating, or writing. In such instances the applied additive does not affect or alter the chemical/physical composition of the first material. The additive itself directly absorbs light having a second wavelength, which results in heating of the first material.

The first and second materials may be respective first and second substrates. The first and second substrates may be substrates of a microfluidic device.

Disclosed herein is a method of joining a first substrate and a second substrate that includes disposing a pattern on the surface of a first substrate, wherein such pattern may be formed by (i) exposing the substrate to a laser beam with a first wavelength, (ii) printing a pattern using a pigment composition, or (iii) scribing a line using a marker implement. Subsequently contacting the patterned substrate with a second substrate; exposing the patterned substrate in contact with the second substrate with a laser beam having a second wavelength, different to the first wavelength, wherein the presence of pattern on the first substrate absorbs the second wavelength laser energy thereby heating and melting the first substrate, resulting in joining of the parts.

A method of joining a first substrate to a second substrate, may include exposing a portion of the first substrate to first laser to carbonise the surface of the substrate, followed by contacting the first substrate with the second substrate, applying a force between the first and second substrates; exposing the first and second substrates to a second laser to heat the surface of the first substrate previously exposed to the first laser, and thereby lead to melting of at least the first substrate and optionally the second substrate; such that the first and second substrate comingle in the proximity of the region contacted by the second laser, thereby joining the substrates.

Also disclosed herein is a method of joining first and second substrates, that includes irradiating a portion of the first substrate with a laser having a first wavelength; contacting the irradiated portion of the first substrate with the second substrate; and irradiating the previously irradiated portion of the first substrate in contact with the second substrate with a laser having a second wavelength, different to the first laser.

The first substrate may comprise a feature, and the portion of first substrate exposed to a first laser is in the proximity of the perimeter of the feature. The feature may be a groove, a channel, a hole, a well, a vent, or a passage. When the surface of the first substrate is exposed to a first laser it is modified by the first laser, making it susceptible to a second laser. The first laser may cause carbonisation of the surface of the first substrate.

The first laser may have a wavelength of between about 238nm and about 532nm, and may include an ultraviolet laser or a green laser. The second laser may have a wavelength of between about 700nm and 1540nm, and may include an infra red laser.

The second substrate may be joined to the first substrate in proximity of the carbonised surface when the infra red laser causes melting of the first substrate, and optionally the second substrate, in the region previously exposed to the first laser. The first substrate may comingle with the second substrate in the region of the first substrate previously exposed to first laser.

The portion of first substrate contacted by the first laser may define a line around the feature to be joined; and in some cases the portion of first substrate contacted by the first laser defines at least two, and in some case three or more lines around the feature or features to be joined.

The portion of first substrate contacted by the first laser may be at a distance of at least about 0.05µm, at least about 0.075µm, at least about 0.1µm, at least about 0.2µm, at least about 0.5µm, at least about 1µm, at least about 2.5µm, at least about 5µm, at least about 10µm, at least about 20µm, at least about 30µm, at least about 50µm from the feature to be joined.

The portion of first substrate contacted by first laser may be at a distance of about 100µm or less, about 75µm or less, about 50µm or less, about 25µm or less, about 10µm or less, about 5µm or less, about 2.5µm or less, about 1µm or less, about 0.5µm or less, from the feature to be joined.

The first laser may provide a continuous line on the surface of the first substrate, or the first laser may provide a series of discrete patterns on the surface of the first substrate. The line or patterns may have a diameter of at least about 0.1µm to at least about 100µm and a spacing of at least about 0.1µm to at least about 100µm may also be used. The first laser may define a circular pattern, a square pattern, a hexagonal pattern, a triangular pattern, or an oval pattern on the surface of the first substrate.

Disclosed herein is a method which includes increasing an absorbance of a portion of the surface of a first substrate to light having a first wavelength; contacting the portion of the surface of the first substrate with a portion of a surface of a second substrate; and irradiating the contacted portions of the first and second substrates with light having the first wavelength having an intensity sufficient to join the first and second substrates at the irradiated portions of the surfaces thereof.

An article of manufacture includes joining a first substrate to a second substrate, in which a portion of at least one of the first and second substrate is exposed to a first laser, which results in melting of the substrate and joining to the other substrate.

In the first aspect of the invention, the method includes providing a structure on a first portion of a surface of the first substrate, which structure acts as an energy director and irradiating a second portion of the same surface of the first substrate with a laser having a first wavelength. The patterned surface of the first substrate is then contacted with a second substrate and ultrasonic radiation is applied to a surface of the second substrate in proximity of the energy director on the first substrate. Subsequently the previously irradiated portion of the first substrate that is in contact with the second substrate is irradiated with a laser having a second wavelength, different to the first wavelength. The first substrate may comprise a feature, which may be a groove, a channel, a hole, a well, a vent, or a passage. An energy director may be provided in the proximity of a first portion of the perimeter of the feature. The application of ultrasonic energy to the second substrate in proximity of the energy director on the first substrate may be used to join the first substrate to the second substrate. A portion of first the substrate exposed to the first laser may be in the proximity of a second portion of a perimeter of the feature, and when the surface of the first substrate is exposed to the first laser it is modified by the first laser, making it susceptible to a second laser. In some instances the first laser causes carbonisation of the surface of the first substrate.

Typically the first laser has a wavelength of between about 238nm and about 532nm; and may be an ultraviolet laser, or a green laser. Typically the second laser has a wavelength of between about 700nm and 1540nm; and may be an infra red laser.

In an embodiment the second substrate is joined to the first substrate in proximity of the carbonised surface. The infra red laser causes melting of the first substrate, and optionally the second substrate, in proximity of the region exposed to first laser which results in the first substrate becoming comingled with the second substrate in the region of the first substrate previously exposed to the first laser.

In an embodiment the portion of first substrate contacted by the first laser defines a line around a feature to be joined. In another embodiment the portion of first substrate contacted by the first laser defines at least two lines around the feature to be joined. Typically the portion of first substrate contacted by the first laser is at a distance of at least about 0.05µm, at least about 0.075µm, at least about 0.1 µm, at least about 0.2µm, at least about 0.5µm, at least about 1µm, at least about 2.5µm, at least about 5µm, at least about 10µm from the feature to be joined. The portion of first substrate contacted by the first laser may also be at a distance of at least about 100µm, at least about 75µm, at least about 50µm, at least about 25µm, at least about 10µm, at least about 5µm, at least about 2.5µm, at least about 1µm, at least about 0.5µm from the feature to be joined.

In an embodiment the first laser defines a continuous line on the surface of the first substrate. In another embodiment the first laser defines a series of discrete patterns having a diameter of at least about 0.1 µm to at least about 10µm and an inter pattern spacing of at least about 0.1µm to at least about 10µm. The first laser may define a circular pattern, a square pattern, a hexagonal pattern, a triangular pattern, an oval pattern on the surface of the first substrate.

In one embodiment the first substrate and second substrate may be joined by laser welding in the absence of any externally applied force.

### BRIEF DESCRIPTION OF FIGURES

Figure 1 shows a perspective view of a first substrate comprising a groove.
Figure 2 shows the first substrate of Fig. 1 being irradiated by a laser beam.
Figure 3 shows the first substrate of Figs. 1 and 2, where a further portion of the substrate has been exposed to the laser beam.
Figure 4 shows a perspective view of the first substrate of Figs. 1-3 with the first substrate in contact with a second substrate and where a portion of the first substrate irradiated by the laser beam as in Figs. 2-3 is being exposed to a second, different laser beam.
Figure 5 shows the view of Fig 4, where the entire portion of the first substrate exposed to a first laser beam, is now simultaneously exposed to a second laser beam of a second wavelength.
Figures 6a-6d show views from above of the first substrate of Fig 1, in which a series of regions irradiated by a laser beam are depicted. In Fig 6a a series of discrete lines are shown formed by spots; Fig 6b shows a series of lines irradiated by a first laser; Fig 6c shows a series of spots arranged in a cubic pattern; Fig 6d shows a series of spots arranged in a triangular pattern.
Figure 7 shows the perspective view of Fig.1 where a region of the device has been exposed to a first laser, and where a region of the device has been modified to provide an energy director.
Figure 8 is a cross sectional view through line A-A of Fig 7
Figure 9 is a cross sectional view of Fig 8 where a second substrate has been placed in contact with the first substrate.

### DETAILED DESCRIPTION OF THE INVENTION

The formation of microfluidic devices often involves joining two substrates together. One or both of the substrates may define microscale features, such as grooves, recesses, channels, holes, pits, wells, vents, passages and apertures. Joining the substrates encapsulates the microscale features to form a microfluidic network that can be used to transport a fluid sample. As such, it is generally preferable that substrates are joined together in such a way that fluid disposed within the microfluidic network cannot leak or escape. It may also be desirable that the gap distances between surfaces of such features be precisely controlled in order to achieve reproducible volume capacity, and further to achieve reproducible capillary pressure, which may be the sole motive force used to move fluid through the microfluidic network.

A process for joining a first substrate to a second substrate is described. The process may include irradiating a portion of a first substrate with a laser beam having a first wavelength and intensity sufficient to increase the absorbance of the first substrate to light having a second, different wavelength. For example, the laser beam may carbonize at least a portion of the irradiated portion of the first substrate. The carbonized portion of the first substrate typically has a higher absorbance to light than non-irradiated portions of the first substrate. A second substrate is then placed in contact with the irradiated portion of the first substrate. With the first and second substrates in such contact, the irradiated portion of the first substrate is irradiated with a second laser having a second wavelength, different to the first wavelength; with a sufficient intensity to heat and, preferably melt, the irradiated portion of the first substrate. Because the absorbance of irradiated portions of the first substrate is higher than that of non-irradiated portions of the first substrate, the second laser beam efficiently heats (and preferably melts) the previously irradiated portions of the first substrate causing the first and second substrates to become joined together, without substantially affecting portions of the substrate not previously exposed to the first wavelength laser. In embodiments, the joined first and second substrates form at least a portion of a microfluidic device.

The process to join two substrates described in the previous paragraph may additionally involve the use of ultrasonic welding. A structure referred to as an energy director may also be provided around the perimeter of the feature to be joined. An energy director is typically a pointed feature present on the surface of one substrate that is to be joined to another substrate. The energy director, when exposed to ultrasonic energy, as the two substrates to be joined are compressed together, is caused to vibrate and therefore generate heat. Such heat leads to melting of the substrate, which under pressure leads to fusing of the substrates to form a joint. The pre-joining of two substrates using ultrasonic welding, may adequately hold the substrates together such that laser welding may be achieved without requirement for compressive pressure being applied to the parts during laser welding. This may be of particular benefit when parts are to be joined at distinct regions using laser welding on a conveyer belt like process.

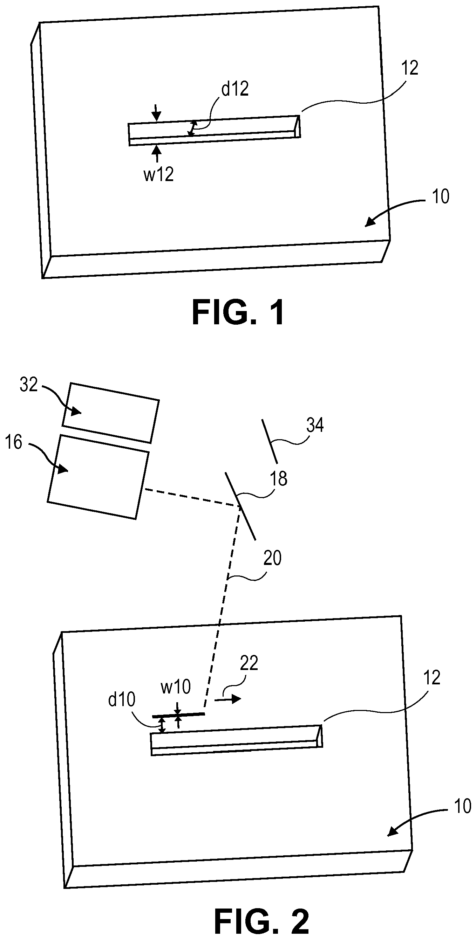

With reference to Fig. 1, a substrate 10 defines a first surface 11 defining a groove 12 having a width w12 microns and a depth d12 microns. First substrate 10 is formed of a material that can be joined to a second substrate by a process including laser irradiation, and or ultrasonic irradiation. Typically, the first substrate includes a polymeric material, such as polystyrene, polycarbonate, polymethylmethacrylate, polyester, polyetheretherketone, or combination thereof. In embodiments, the first substrate is opaque to light having a wavelength between about 300 nm and about 1000 nm. The term "groove" is used herein as a non limiting example of the term "feature" for the purpose of describing a specific embodiment. The term "feature" is used to define a groove, a channel, a hole, a well, a vent, a passage, a pit or other such structures or elements.

In certain embodiments, width w12 of groove 12 may be at least about 250µm (e.g. at least about 500µm, at least about 750µm, at least about 1000µm, at least about 2500µm, at least about 5000µm)

In other embodiments width w12 of groove 12 may be about 0.5mm (e.g. less than about 0.4mm, less than about 0.3mm, less than about 0.2mm, less than about 0.1mm, less than about 0.05mm, less than about 0.01mm).

Depth d12 of groove 12 may by about 250µm (e.g. at least about 500µm, at least about 750µm, at least about 1000µm, at least about 1.5mm). In other embodiments depth d12 of groove 12 may by about 250µm (e.g. less than about 200µm, less than about 150µm, less than about 100µm, less than about 75µm, less than about 50µm, less than about 25µm, less than about 20µm, less than about 10µm, less than about 5µm).

Groove 12 may be formed in the surface of first substrate 10 by a variety of processes, including but not limited to injection molding, hot embossing, extrusion molding, engraving, laser ablation, micro machining, or the like.

Referring to Figure 2 a process of exposing a portion of a first substrate 10 to a laser beam 20 is provided. First laser 16 produces a laser beam 20 having a first wavelength. Second laser 32 produces a laser beam (not shown) having a second wavelength, different from first laser 16. The first wavelength is selected to cause carbonisation of the surface of first substrate 10. Carbonised line 14, having a width wl4, is produced on the surface of first substrate 10 following exposure of first substrate 10 to laser beam 20. Width w14 of carbonised line 14 may be at least about 50µm (e.g. at least about 52µm, at least about 54µm, at least about 56µm, at least about 58µm, at least about 60µm, at least about 65µm, at least about 70µm, at least about 80µm). Width w14 of carbonised line 14 may be at least about 50µm (e.g. less than about 45µm, less than about 40µm, less than about 35µm, less than about 30µm, less than about 25µm, less than about 10µm).

In an exemplary embodiment, laser 16 may be described by the following characteristics: wavelength 355nm or 532nm; used with the following operational parameters (when using a Samurai UV laser marking system) laser power 100%, laser frequency 50Hz; laser on delay 50µs; laser off delay 135µs; mark delay 0µs, mark speed 3000mm/s, pulse width 2µs, jump speed 150µs, mode- mark once.

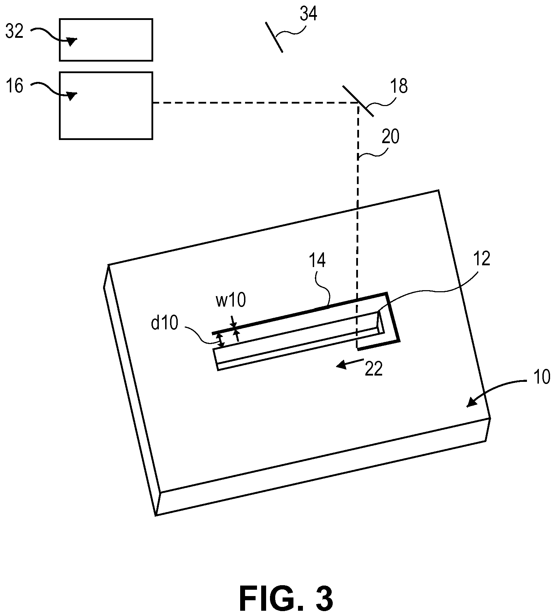

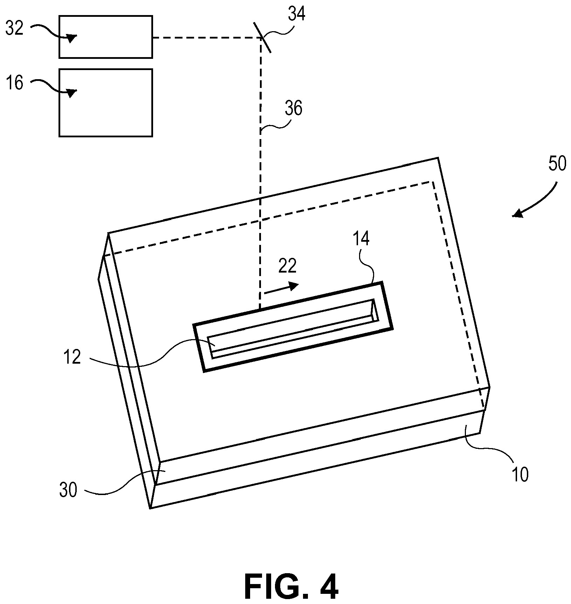

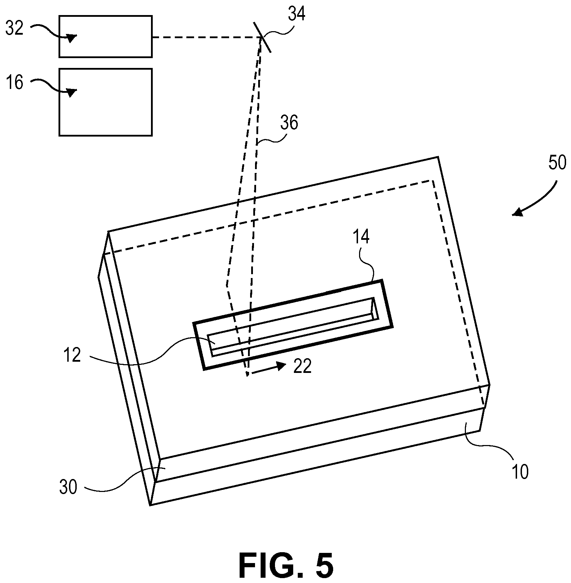

Laser beam 20 is directed onto first substrate 10 using a first optical arrangement 18. First optical arrangement 18 may be used to direct the first laser beam 20 to make specific contact with the surface of first substrate 10. In the specific embodiment depicted in Figure 2, laser beam 20 is directed to make contact with the surface of first substrate 10 at a distance d10 from the edge of groove 12 present on the surface of first substrate 10. Distance d10 may be about 30µm, (e.g. at least about 32µm, at least about 35µm, at least about 40µm, at least about 45µm, at least about 50µm). Distance d10 may be about 30µm (e.g. less than about 25µm, less than about 20µm, less than about 15µm, less than about 10µm, less than about 5µm). First optical arrangement 18 is used to steer laser beam 20 along a path in direction of arrow 22, maintaining a distance d10 parallel to the edge of groove 12 to produce carbonised line 14. Figure 3 depicts the view of Fig 2, indicating the progress of forming carbonised line 14 around the perimeter of groove 12. First optical arrangement 18 is manipulated to direct laser beam 16 along a defined path around the feature of interest to be joined. In the embodiment displayed in Fig. 2 the feature to be joined is groove 12, as will be described with reference to Figs 4 and 5.

First laser 16 is selected to provide a range of wavelengths of light which can be used to modify or carbonise the surface of first substrate 10, rendering the contacted portion susceptible to light of a second wavelength. For example, in one embodiment, first laser 16 may be an ultra violet laser, in another embodiment first laser 16 may be a green laser. Typical wavelengths for first laser 16 may be in the range from about 248nm to about 532nm. First laser 16 is selected such that it causes carbonisation of the surface of first substrate 10, without substantially altering the surface profile. That is to say, the process of carbonisation does not substantially result in formation of either a depression in the surface of first substrate 10, or a raised elevation on the surface of first substrate 10. The process of modifying or carbonisation of the surface of first substrate 10 is provided to alter the absorption characteristics of first substrate 10, thereby making it susceptible to a laser of different wavelength. Such a laser of different wavelength may induce heating and melting of an appropriately susceptible polymer surface. For example a polymer that contains particles of carbon black, such as for example black polystyrene, may directly adsorb laser energy of the wavelength that may induce heating and melting of the polymer. As such the entire surface of a black polystyrene would be susceptible to a laser of wavelength sufficient to cause heating and melting of the surface. A benefit of the present invention is that unique and discrete regions on the surface of first substrate 10 can be "activated" through use of first laser 16. Such patterning or marking of discrete regions of first substrate 10 can mitigate unwanted heating in certain locations, for example in locations in which a protein or other temperature sensitive species or component may have been deposited.

Referring now to Fig 4, a second substrate 30 is disposed on the surface of first substrate 10 upon which a carbonised line 14 has been formed to yield microfluidic chip 50. A second laser 32 is then used to provide a laser beam 36 that is directed to the surface of first substrate 10 using second optical arrangement 34. Second substrate 30 is selected from a polymeric material that is transparent to, and non-susceptible to heating and melting caused by laser beam 36. In one embodiment, as depicted in Fig 4, laser beam 36 is steered in direction of arrow 22 to follow carbonised line 14. In another embodiment, as depicted in Fig 5, laser beam 36 exposes the entire area on which carbonised line 14 is disposed simultaneously, using a "curtain beam" which defines a line rather than a spot on the surface of the target.

Second laser 32 is selected to provide a range of wavelengths of light that can be used to cause localised heating and/or melting of the surface of first substrate 10, in the proximity of carbonised line 14. In an alternative embodiment, the polymer from which first substrate 10 is formed may be a material that directly absorbs energy from laser 32. For example, polystyrene loaded with carbon black may be used; such material will be naturally susceptible to heating and/or melting when contacted by second laser 32. It should be noted however, that when first substrate 10 is formed from black polystyrene, for example, it may be necessary to use a mask to restrict areas of first substrate 10 that are exposed to second laser 32 to prevent unwanted heating and melting in certain parts. When white polystyrene, for example, is used to produce first substrate 10, such material is generally not susceptible to second laser 32, and absent carbonised line 14, such material does not undergo heating and/or melting when contacted by second laser 32. Typically an infra red laser having a wavelength in the order of 750 nm to about 1500nm may be selected to cause heating and/or melting of first substrate 10 that has previously been exposed to first laser 16. In an exemplary embodiment second laser 32 has a wavelength of 940nm.

When carbonised line 14 is exposed to laser beam 36, laser energy is absorbed by carbonised line 14 which results in the localised heating of first substrate 10 in the proximity of carbonised line 14. The polymers of first substrate 10 and second substrate 30 subsequently melt as a result of the localised heating caused by laser beam 36. The molten polymers comingle, and as the polymers subsequently cool once laser beam 36 has been switched off, the first substrate 10 and second substrate 30 become joined in proximity of carbonised line 14 formed on the surface of first substrate 10. As depicted in Fig 4, second optical arrangement 34 is used to steer laser beam 36 around the path of carbonised line 14 in the direction of arrow 22. Carbonised line 14 is sensitive to laser beam 36, to the extent energy form laser beam 36 results in localised temperature elevation leading to melting of first substrate 10, and optionally second substrate 30, in the immediate proximity of carbonised line 14. As laser beam 36 is steered along carbonised line 14, the polymers of first substrate 10 and second substrate 30 melt and comingle, leading to the substrates becoming joined along the length of carbonised line 14.

With reference to Fig 5, groove 12 around which carbonised line 14 of microfluidic chip 50 is present is simultaneously exposed to laser beam 36. In this embodiment, optical arrangement 34 produces a wedge or curtain shaped laser beam 36 sufficient to affect heating of the entire length and or width of carbonised line 14 in a single step. In this instance, laser beam 36 is not steered around carbonised line 14, as described with reference to Fig 4, but contacts the entire area on which carbonised line 14 has been formed. Alternatively wedge or curtain shaped laser beam 36 may be scanned across the surface of first substrate 10, in which case either the length or width of the part to be joined is exposed across a line of contact made between the laser beam 36 and the surface; in contrast to the point contact between laser beam 36 and first substrate 10 as described with reference to Fig 4. In some embodiments when exposing microfluidic chip 50 to either a wedge or curtain shaped beam, it may be necessary to apply a mask to certain areas of first substrate 10 to prevent exposure of potentially sensitive areas of microfluidic chip 50 to laser beam 36. For example, if a biological or chemical material that might be denatured upon exposure to second laser 32 has been deposited within a groove or channel in microfluidic chip 50, it may be necessary to prevent exposure of such material to laser 32.

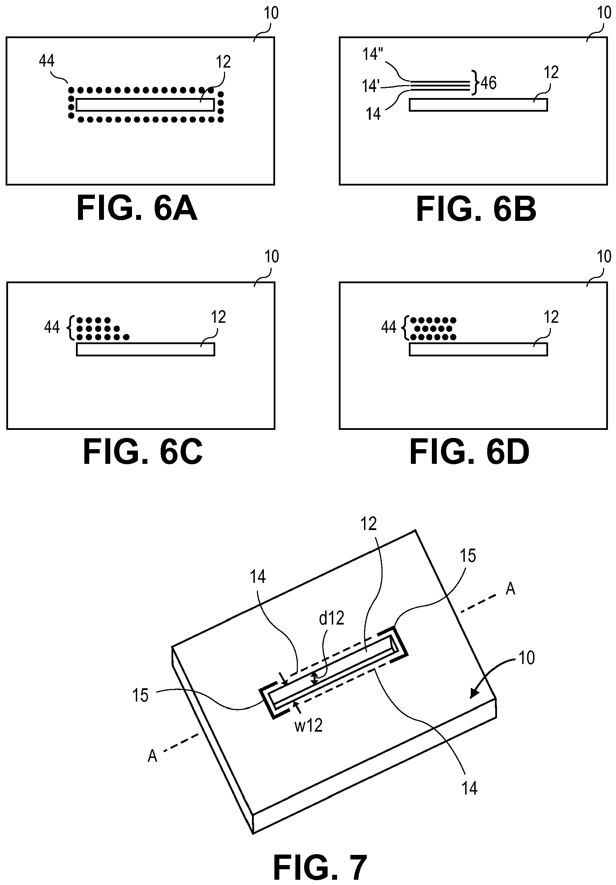

In further embodiments, multiple carbonised lines 14 may be formed upon the surface of first substrate 10. For example, carbonised lines 14, 14', 14" may be provided as a series of spots 44 having a diameter of about 50µm (e.g. at least about 52µm, at least about 54µm, at least about 56µm, at least about 58µm, at least about 60µm, at least about 65µm, at least about 70µm, at least about 80µm). Carbonised lines 14, 14', 14" may also be provided as a series of spots 44 having a diameter of about 50µm (e.g. less than about 45µm, less than about 40µm, less than about 35µm, less than about 30µm, less than about 25µm, less than about 10µm) as depicted in Fig 6a. Optionally, carbonised lines 14, 14', 14" may be provided as a series of lines 46 having a width of about 50µm (e.g. at least about 52µm, at least about 54µm, at least about 56µm, at least about 58µm, at least about 60µm, at least about 65µm, at least about 70µm, at least about 80µm). Optionally, carbonised lines 14, 14', 14" may be provided as a series of lines 46 having a width of about 50µm (e.g. less than about 45µm, less than about 40µm, less than about 35µm, less than about 30µm, less than about 25µm, less than about 10µm) as depicted in Fig 6b. According to Fig 6a or 6b, carbonised lines 14, 14', 14" may be separated by a gap distance of about 10µm (e.g. at least about 12µm, at least about 14µm, at least about 16µm, at least about 18µm, at least about 20µm, at least about 25µm, at least about 30µm, at least about 40µm). According to Fig 6a or 6b, carbonised lines 14, 14', 14" may be separated by a gap distance of about 10µm (e.g. less than about 8µm, less than about 6µm, less than about 4µm, less than about 2µm, less than about 1µm).

As depicted in Fig 6a each spot may have a circumferential gap distance from the next spot of about 10µm (e.g. at least about 12µm, at least about 14µm, at least about 16µm, at least about 18µm, at least about 20µm, at least about 25µm, at least about 30µm, at least about 40µm). As depicted in Fig 6a each spot may have a circumferential gap distance from the next spot of about 10µm (e.g. less than about 8µm, less than about 6µm, less than about 4µm, less than about 2µm, less than about 1µm). Furthermore, spots may be placed in different spatial arrangements. In one embodiment spots may be arranged in a cubic pattern arrangement, as depicted in Fig 6c, in which the centres of spots in neighbouring rows define a cubic pattern. In a further embodiment, spots 44 may be displaced such the centres of spots in neighbouring rows define a triangular pattern, as shown in Fig 6d. Dependent upon the purpose of microfluidic chip 50, as depicted in Figs 4 and 5, two or more carbonised lines may be provided around the perimeter of groove 12. It will be apparent to the skilled person that with increased number of carbonised lines 14, 14', 14" used to join first substrate 10 and second substrate 30, a more robust joint between the two substrates will occur, since the area of contact within which the polymers have been melted and comingled will be increased.

In yet further embodiments provision of carbonised lines 14, 14', 14" on the surface of first substrate 10 may be achieved by a variety of processes. For example, carbonised line 14, 14', 14" may be formed by a process of printing, such as screen printing, gravure printing, slot dye printing, rotary printing, ink-jet printing or other non-contact printing methods which are used to deposit a thin layer of material that will adsorb laser beam 36 and lead to heating and melting of first and second substrates (10, 30). In some embodiments a material containing particles of carbon, may be deposited onto the surface of first substrate 10. In other embodiments a material containing other particles or additives that will adsorb energy form second laser 32 may be used. The purpose of such particles is to induce heating and melting of first substrate 10, when the material is exposed to second laser 32. When such a composition is applied to the surface of first substrate 10, the composition does not substantially affect or alter the chemical composition of first substrate 10. Rather the composition is susceptible to absorb energy from second laser 32 to generate heat, which results in the melting of first substrate 10 prior to formation of a joint or bond between first substrate 10 and second substrate 30.

In a further embodiment the application of a thin layer of material to the surface of first substrate 10 causes a chemical change to the composition of first substrate 10. In which case the areas of first substrate 10 contacted by such an applied material may become susceptible to second laser 32. Thus following treatment of first substrate 10, the portions chemically modified may be contacted by second laser 32 leading to heating and joining to second substrate 30 in regions proximate the points of contact between first substrate 10 and second substrate 30 wherein first substrate 10 has previously been chemically modified by application of a thin layer of material thereto.

Carbonised line 14 may additionally be formed by a process of co-molding, in which a carbon loaded polymer is specifically injected into a mold tool to provide one or more discrete lines or regions on the surface of a part to be joined. In yet a further embodiment, a line may be scribed on the surface of first substrate 10 using a pen, for example a felt tipped pen that uses a carbon pigment ink, or other pigment that will adsorb energy from second laser 32 and result in heating and melting of at least first substrate 10, and optionally additionally second substrate 30.

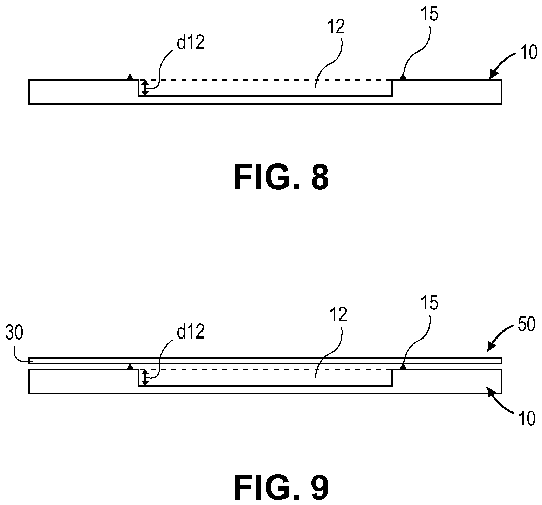

With reference to Figure 7, in certain embodiments groove 12 may be circumscribed by energy director 15 and carbonised line 14. Energy director 15 represents a raised portion which can be seen more clearly in Figure 8, which is a cross sectional view through line A-A of Figure 7. An energy director 15 is a structure or feature presented on the surface of substrate 10 that is susceptible to ultrasonic radiation. Energy director 15 makes initial contact with second substrate 30, when the first and second substrates are first brought into contact, as depicted in Figure 9. When ultrasonic energy is applied to the outer surface (that surface not in contact with first substrate 10) of second substrate 30 in the proximity of energy director 15 on first substrate 10, the vibrational energy causes localised heating of the polymeric materials from which energy director 15 is formed at the junction between the two substrates. Compressive pressure applied to the first and second substrates at the point of applying ultrasonic energy results in joining of the two substrates. The energy director heats and melts as it compressed, when exposed to ultrasonic energy, fusing with the second substrate. Typically frequencies in the range 15 kHz, 20 kHz, 30 kHz, 35 kHz, 40 kHz and 70 kHz may be utilised according to the composition of the polymers to be joined. An energy director 15 may be formed by a variety of procedures, including, but not limited to, injection moulding, hot embossing, laser scribing, milling of the plastic substrate following injection moulding, extrusion of the plastic part, or dispensing of a material onto the surface of the moulded part which subsequently hardens to form an energy director. Typically an energy director 15 would be formed simultaneously with formation of groove 12 by injection moulding.

According to one embodiment of the present invention, following the initial formation of carbonised line 14 by laser beam 20 (as depicted in Figure 2), first and second substrates would be placed in contact and be compressed against a glass plate (not shown) with second substrate 30 in direct contact with the glass plate. Second laser 32 would then be directed through the glass plate to contact carbonised line 14 as previously described with respect to Figures 3-5, leading to joining of the substrates. Under certain conditions it may however be favourable to be able to implement the laser welding step without the requirement to compress the parts to be joined against a glass plate during the welding process. In the present invention, a combination of ultrasonic and laser welding to join two work parts, is used. In the first instance the parts may be joined using ultrasonic welding. The ultrasonic weld joint holds the parts sufficiently close together to facilitate successful laser welding. Consequently there is no subsequent requirement for parts to be compressed against a glass plate during the laser welding step.

Laser welding of parts typically yields a joint between the parts that is more reproducible with respect to the gap height between the two parts joined together when compared with the gap height achieved using ultrasonic welding alone. This is in part because there is no additional material to be accommodated in the region of the joint, namely the volume occupied by the energy director 15, which may give rise to variability in the gap height between the two substrates. Thus in circumstances where it is desirable to have a more reproducible gap height, for example in microfluidic devices which operate using a process of capillary fill, variations in dimensions of an enclosed cavity, such as a capillary, may result in variable fluid flow rates within such capillaries. Where such devices are used in performing assay measurements, any variability in the component part may be sufficient to impact precision of assay measurements. It is thus of benefit to provide improved control over the assembly process using the combined process using ultrasonic and laser welding. A further benefit of the combined ultrasonic/laser welding process is that the laser welding step may be semi-automated to use a conveyer belt operation, in which parts previously joined together using ultrasonic welding may be exposed to second laser 32 as described with reference to Fig 5, where a curtain beam is used that exposes all regions on the surface of substrate 10 previously exposed to first laser 16 as the parts pass beneath second laser 32 on a conveyer belt (not shown).

## Claims

1. A method of joining a first substrate (10) to a second substrate (30), comprising;
(a) providing a structure on a first portion of a surface of the first substrate (10), which structure acts as an energy director (15);
(b) irradiating a second portion of the same surface of the first substrate (10) with a laser (16) having a first wavelength;
(c) contacting the patterned surface of the first substrate (10) with a second substrate (30);
(d) applying ultrasonic radiation to a surface of the second substrate (30) in proximity of the energy director (15) on the first substrate (10);
(e) irradiating the previously irradiated portion of the first substrate (10) that is in contact with the second substrate (30) with a laser (32) having a second wavelength, different to the first wavelength, optionally wherein the first substrate (10) and second substrate (30) are joined by laser welding in the absence of an externally applied force.

2. A method of joining a first substrate (10) and a second substrate (30), comprising;
(a) disposing a first pattern on a surface of the first substrate (10), wherein such pattern may be formed by either
(i) injection moulding, or
(ii) hot embossing, or
(iii) milling, or
(iv) extruding, or
(v) dispensing;
(b) disposing a second pattern on the surface of the first substrate (10), wherein such pattern may be formed by either
(i) exposing the substrate to a laser (16) with a first wavelength, or
(ii) printing a pattern using a pigment composition, or
(iii) scribing a line using a marker implement;
(c) contacting the patterned substrate with a second substrate (30);
(d) exposing the patterned first substrate (10) in contact with the second substrate (30) to ultrasonic energy in proximity of the first pattern, wherein the presence of the first pattern on the substrate absorbs ultrasonic energy, generating localised melting of the substrate, thereby joining the first (10) and second substrate (30) in the proximity of the first pattern;
(e) exposing the patterned substrate in contact with the second substrate (30) to a laser beam having a second wavelength, different to the first wavelength, wherein the presence of the second pattern on the first substrate (10) absorbs the second wavelength laser energy thereby heating and melting the first substrate (10) in proximity of the second pattern, optionally wherein the first substrate (10) and second substrate (30) are joined by laser welding in the absence of an externally applied force.

3. The method of any preceding claim wherein the first substrate (10) comprises a feature which optionally comprises a groove (12), a channel, a hole, a well, a vent, or a passage.

4. The method of claim 3 when dependent on claim 1 wherein the energy director (15) is in the proximity of a first portion of the perimeter of the feature.

5. The method of claim 3 or claim 4 when dependent on claim 1, wherein application of ultrasonic energy to the second substrate (30) in proximity of the energy director (15) on the first substrate (10) is used to join the first substrate (10) to the second substrate (30).

6. The method of any one of claims 3-5 wherein the portion of first substrate (10) exposed to the first laser (16) is in the proximity of a second portion of a perimeter of the feature and/or wherein (i) the portion of first substrate (10) contacted by the first laser (16) defines a line around the feature to be joined or (ii) the portion of first substrate (10) contacted by the first laser (16) defines at least two lines around the feature to be joined.

7. The method of any preceding claim wherein the surface of the first substrate (10) exposed to the first laser (16) is modified by the first laser (16), making it susceptible to a second laser (32).

8. The method of any preceding claim wherein the first laser (16) causes carbonisation of the surface of the first substrate (10).

9. The method of any preceding claim wherein the first laser (16) has a wavelength of between about 238nm and about 532nm, optionally wherein the first laser (16) is an ultraviolet laser or a green laser.

10. The method of any preceding claim wherein the second laser (32) has a wavelength of between about 700nm and 1540nm and/or is an infra-red laser, optionally wherein the infra-red laser causes melting of the first substrate (10), and optionally the second substrate (30), in proximity of the region exposed to first laser (16).

11. The method of any preceding claim wherein the second substrate (30) is joined to the first substrate (10) in proximity of the modified surface.

12. The method of claim 11 wherein the first substrate (10) comingles with the second substrate (30) in the region of the first substrate (10) previously exposed to the first laser (16).

13. The method of any one of claims 3 or 4-12 when dependent on claim 3, wherein the portion of first substrate (10) contacted by the first laser (16) is at a distance of at least about 0.05µm, at least about 0.075µm, at least about 0.1 µm, at least about 0.2µm, at least about 0.5µm, at least about 1µm, at least about 2.5 µm, at least about 5µm, at least about 10µm from the feature to be joined or wherein the portion of first substrate (10) contacted by first laser (16) is at a distance of about 100µm or less, about 75µm or less, about 50µm or less, about 25µm or less, about 10µm or less, about 5µm or less, about 2.5µm or less, about 1µm or less, or about 0.5µm or less from the feature to be joined.

14. The method of any preceding claim where the first laser (16) (i) provides a continuous line on the surface of the first substrate (10), or (ii) provides a series of discrete patterns having a diameter of at least about 0.1 µm to at least about 10µm and a spacing of at least about 0.1µm to at least about 10µm, optionally wherein the first laser (16) defines a circular pattern, a square pattern, a hexagonal pattern, a triangular pattern, an oval pattern on the surface of the first substrate (10).

## Patentansprüche

1. Verfahren zum Zusammenfügen eines ersten Substrats (10) mit einem zweiten Substrat (30), umfassend:
(a) Bereitstellen einer Struktur auf einem ersten Abschnitt einer Fläche des ersten Substrats (10), wobei die Struktur als Energierichter (15) wirkt;
(b) Bestrahlen eines zweiten Abschnitts derselben Fläche des ersten Substrats (10) mit einem Laser (16) mit einer ersten Wellenlänge;
(c) Inkontaktbringen der gemusterten Fläche des ersten Substrats (10) mit einem zweiten Substrat (30) ;
(d) Anlegen von Ultraschallstrahlung an eine Fläche des zweiten Substrats (30) in der Nähe des Energierichters (15) auf dem ersten Substrat (10);
(e) Bestrahlen des zuvor bestrahlten Abschnitts des ersten Substrats (10), der mit dem zweiten Substrat (30) in Kontakt steht, mit einem Laser (32) mit einer zweiten Wellenlänge, die von der ersten Wellenlänge verschieden ist, wobei gegebenenfalls das erste Substrat (10) und das zweite Substrat (30) durch Laserschweißen in Abwesenheit einer extern ausgeübten Kraft zusammengefügt werden.

2. Verfahren zum Zusammenfügen eines ersten Substrats (10) mit einem zweiten Substrat (30), umfassend:
(a) Anordnen eines ersten Musters auf einer Fläche des ersten Substrats (10), wobei ein solches Muster gebildet werden kann entweder durch
(i) Spritzgießen, oder
(ii) Heißprägen, oder
(iii) Mahlen, oder
(iv) Extrudieren, oder
(v) Abgeben;
(b) Anordnen eines zweiten Musters auf der Fläche des ersten Substrats (10), wobei ein solches Muster gebildet werden kann entweder durch
(i) Belichten des Substrats mit einem Laser (16) mit einer ersten Wellenlänge, oder
(ii) Drucken eines Musters unter Verwendung einer Pigmentzusammensetzung, oder
(iii)Ritzen einer Linie unter Verwendung einer Markervorrichtung;
(c) Inkontaktbringen des gemusterten Substrats mit einem zweiten Substrat (30);
(d) Aussetzen des gemusterten ersten Substrats (10) in Kontakt mit dem zweiten Substrat (30) an Ultraschallenergie in der Nähe des ersten Musters, wobei die Anwesenheit des ersten Musters auf dem Substrat Ultraschallenergie absorbiert, wobei ein lokalisiertes Schmelzen des Substrats erzeugt wird, wodurch das erste (10) und zweite (30) Substrat in der Nähe des ersten Musters zusammengefügt werden;
(e) Belichten des gemusterten Substrats in Kontakt mit dem zweiten Substrat (30) mit einem Laserstrahl mit einer zweiten Wellenlänge, die von der ersten Wellenlänge verschieden ist, wobei die Anwesenheit des zweiten Musters auf dem ersten Substrat (10) die Laserenergie mit der zweiten Wellenlänge absorbiert, wodurch das erste Substrat (10) in der Nähe des zweiten Musters erhitzt und geschmolzen wird, wobei gegebenenfalls das erste Substrat (10) und das zweite Substrat (30) durch Laserschweißen in Abwesenheit einer extern ausgeübten Kraft zusammengefügt werden.

3. Verfahren nach einem der vorhergehenden Ansprüche,
wobei das erste Substrat (10) ein Merkmal umfasst, das gegebenenfalls eine Rille (12), einen Kanal, ein Loch, eine Senke, eine Entlüftung oder einen Durchgang umfasst.

4. Verfahren nach Anspruch 3, wenn von Anspruch 1 abhängig,
wobei der Energierichter (15) in der Nähe eines ersten Abschnitts des Perimeters des Merkmals ist.

5. Verfahren nach Anspruch 3 oder Anspruch 4, wenn von Anspruch 1 abhängig,
wobei das Anlegen von Ultraschallenergie an das zweite Substrat (30) in der Nähe des Energierichters (15) auf dem ersten Substrat (10) verwendet wird, um das erste Substrat (10) mit dem zweiten Substrat (30) zusammenzufügen.

6. Verfahren nach einem der Ansprüche 3 bis 5,
wobei der Abschnitt des ersten Substrats (10), der mit dem ersten Laser (16) belichtet wird, in der Nähe eines zweiten Abschnitts eines Perimeters des Merkmals ist, und/oder wobei (i) der Abschnitt des ersten Substrats (10), der von dem ersten Laser (16) kontaktiert wird, eine Linie rund um das zusammenzufügende Merkmal definiert, oder (ii) der Abschnitt des ersten Substrats (10), der von dem ersten Laser (16) kontaktiert wird, mindestens zwei Linien rund um das zusammenzufügende Merkmal definiert.

7. Verfahren nach einem der vorhergehenden Ansprüche,
wobei die Fläche des ersten Substrats (10), die mit dem ersten Laser (16) belichtet wird, durch den ersten Laser (16) modifiziert wird, wodurch sie für einen zweiten Laser (32) empfindlich wird.

8. Verfahren nach einem der vorhergehenden Ansprüche,
wobei der erste Laser (16) eine Carbonisierung der Fläche des ersten Substrats (10) bewirkt.

9. Verfahren nach einem der vorhergehenden Ansprüche,
wobei der erste Laser (16) eine Wellenlänge von zwischen ungefähr 238 nm und ungefähr 532 nm aufweist, wobei gegebenenfalls der erste Laser (16) ein Ultraviolett-Laser oder ein grüner Laser ist.

10. Verfahren nach einem der vorhergehenden Ansprüche,
wobei der zweite Laser (32) eine Wellenlänge von zwischen ungefähr 700 nm und 1540 nm aufweist und/oder ein Infrarot-Laser ist, wobei gegebenenfalls der Infrarot-Laser ein Schmelzen des ersten Substrats (10) und gegebenenfalls des zweiten Substrats (30) in der Nähe der Region bewirkt, die mit dem ersten Laser (16) belichtet wird.

11. Verfahren nach einem der vorhergehenden Ansprüche,
wobei das zweite Substrat (30) mit dem ersten Substrat (10) in der Nähe der modifizierten Fläche zusammengefügt wird.

12. Verfahren nach Anspruch 11,
wobei sich das erste Substrat (10) mit dem zweiten Substrat (30) in der Region des ersten Substrats (10) vermischt, die zuvor mit dem ersten Laser (16) belichtet wurde.

13. Verfahren nach einem der Ansprüche 3 oder 4 bis 12, wenn abhängig von Anspruch 3,
wobei der Abschnitt des ersten Substrats (10), der von dem ersten Laser (16) kontaktiert wird, in einer Distanz von mindestens ungefähr 0,05 µm, mindestens ungefähr 0,075 µm, mindestens ungefähr 0,1 µm, mindestens ungefähr 0,2 µm, mindestens ungefähr 0,5 µm, mindestens ungefähr 1 µm, mindestens ungefähr 2,5 µm, mindestens ungefähr 5 µm, mindestens ungefähr 10 µm, von dem zusammenzufügenden Merkmal ist, oder wobei der Abschnitt des ersten Substrats (10), der von dem ersten Laser (16) kontaktiert wird, in einer Distanz von ungefähr 100 µm oder weniger, ungefähr 75 µm oder weniger, ungefähr 50 µm oder weniger, ungefähr 25 µm oder weniger, ungefähr 10 µm oder weniger, ungefähr 5 µm oder weniger, ungefähr 2,5 µm oder weniger, ungefähr 1 µm oder weniger, oder ungefähr 0,5 µm oder weniger, von dem zusammenzufügenden Merkmal ist.

14. Verfahren nach einem der vorhergehenden Ansprüche,
wobei der erste Laser (16) (i) eine kontinuierliche Linie auf der Fläche des ersten Substrats (10) bereitstellt, oder (ii) eine Serie diskreter Muster mit einem Durchmesser von mindestens ungefähr 0,1 µm bis mindestens ungefähr 10 µm und einer Beabstandung von mindestens ungefähr 0,1 µm bis mindestens ungefähr 10 µm bereitstellt, wobei gegebenenfalls der erste Laser (16) ein kreisförmiges Muster, ein quadratisches Muster, ein hexagonales Muster, ein dreieckiges Muster, ein ovales Muster auf der Fläche des ersten Substrats (10) definiert.

## Revendications

1. Procédé d'assemblage d'un premier substrat (10) à un second substrat (30), comprenant les étapes consistant à :
(a) fournir une structure sur une première partie d'une surface du premier substrat (10), ladite structure agissant en tant que directeur d'énergie (15) ;
(b) irradier une seconde partie de la même surface du premier substrat (10) avec un laser (16) ayant une première longueur d'onde ;
(c) mettre en contact la surface à motifs du premier substrat (10) avec un second substrat (30) ;
(d) appliquer un rayonnement ultrasonique sur une surface du second substrat (30) à proximité du directeur d'énergie (15) sur le premier substrat (10) ;
(e) irradier la partie précédemment irradiée du premier substrat (10) qui est en contact avec le second substrat (30) avec un laser (32) ayant une seconde longueur d'onde, différente de la première longueur d'onde, éventuellement le premier substrat (10) et le second substrat (30) étant assemblés par soudage au laser en l'absence d'une force appliquée extérieurement.

2. Procédé d'assemblage d'un premier substrat (10) et d'un second substrat (30), comprenant les étapes consistant à :
(a) disposer un premier motif sur une surface du premier substrat (10), ledit motif pouvant être formé par
(i) moulage par injection, ou
(ii) gaufrage à chaud, ou
(iii) fraisage, ou
(iv) extrusion, ou
(v) distribution ;
(b) disposer un second motif sur la surface du premier substrat (10), ledit motif pouvant être formé par
(i) exposition du substrat à un laser (16) ayant une première longueur d'onde, ou
(ii) impression d'un motif à l'aide d'une composition pigmentaire, ou
(iii) tracé d'une ligne à l'aide d'un outil de marquage ;
(c) mettre en contact le substrat à motifs avec un second substrat (30) ;
(d) exposer le premier substrat à motifs (10) en contact avec le second substrat (30) à de l'énergie ultrasonique à proximité du premier motif, la présence du premier motif sur le substrat absorbant l'énergie ultrasonique, générant une fusion localisée du substrat, assemblant ainsi le premier (10) et le second substrat (30) à proximité du premier motif ;
(e) exposer le substrat à motifs en contact avec le second substrat (30) à un faisceau laser ayant une seconde longueur d'onde, différente de la première longueur d'onde, la présence du second motif sur le premier substrat (10) absorbant l'énergie laser de seconde longueur d'onde, ce qui permet de chauffer et de fondre le premier substrat (10) à proximité du second motif, éventuellement le premier substrat (10) et le second substrat (30) étant assemblés par soudage au laser en l'absence d'une force appliquée à l'extérieur.

3. Procédé selon l'une quelconque des revendications précédentes, le premier substrat (10) comprenant un élément qui comprend éventuellement une rainure (12), un canal, un trou, un puits, un évent ou un passage.

4. Procédé selon la revendication 3 lorsqu'elle dépend de la revendication 1, le directeur d'énergie (15) se trouvant à proximité d'une première partie du périmètre de l'élément.

5. Procédé selon la revendication 3 ou 4 lorsqu'elle dépend de la revendication 1, l'application d'énergie ultrasonique au second substrat (30) à proximité du directeur d'énergie (15) sur le premier substrat (10) servant à assembler le premier substrat (10) au second substrat (30).

6. Procédé selon l'une quelconque des revendications 3 à 5, la partie du premier substrat (10) exposée au premier laser (16) se trouvant à proximité d'une seconde partie d'un périmètre de l'élément et/ou (i) la partie du premier substrat (10) en contact avec le premier laser (16) définissant une ligne autour de l'élément à assembler ou (ii) la partie du premier substrat (10) en contact avec le premier laser (16) définissant au moins deux lignes autour de l'élément à assembler.

7. Procédé selon l'une quelconque des revendications, la surface du premier substrat (10) exposée au premier laser (16) étant modifiée par le premier laser (16), ce qui la rend sensible à un second laser (32).

8. Procédé selon l'une quelconque des revendications précédentes, le premier laser (16) provoquant la carbonisation de la surface du premier substrat (10).

9. Procédé selon l'une quelconque des revendications précédentes, le premier laser (16) ayant une longueur d'onde comprise entre environ 238 nm et environ 532 nm, éventuellement le premier laser (16) étant un laser ultraviolet ou un laser vert.

10. Procédé selon l'une quelconque des revendications précédentes, le second laser (32) ayant une longueur d'onde comprise entre environ 700 nm et 1 540 nm et/ou étant un laser infrarouge, éventuellement le laser infrarouge provoquant la fusion du premier substrat (10), et éventuellement du second substrat (30), à proximité de la région exposée au premier laser (16).

11. Procédé selon l'une quelconque des revendications précédentes, le second substrat (30) étant assemblé au premier substrat (10) à proximité de la surface modifiée.

12. Procédé selon la revendication 11, le premier substrat (10) étant combiné au second substrat (30) dans la région du premier substrat (10) préalablement exposée au premier laser (16).

13. Procédé selon l'une quelconque des revendications 3 ou 4 à 12 lorsqu'elles dépendent de la revendication 3, la partie du premier substrat (10) mise en contact par le premier laser (16) étant à une distance d'au moins environ 0,05 µm, d'au moins environ 0,075 µm, d'au moins environ 0,1 µm, d'au moins environ 0,2 µm, d'au moins environ 0,5 µm, d'au moins environ 1 µm, d'au moins environ 2,5 µm, d'au moins environ 5 µm, d'au moins environ 10 µm de l'élément à assembler ou la partie du premier substrat (10) mise en contact par le premier laser (16) étant à une distance d'environ 100 µm ou moins, d'environ 75 µm ou moins, d'environ 50 µm ou moins, d'environ 25 µm ou moins, d'environ 10 µm ou moins, d'environ 5 µm ou moins, d'environ 2,5 µm ou moins, d'environ 1 µm ou moins, ou d'environ 0,5 µm ou moins de l'élément à assembler.

14. Procédé selon l'une quelconque des revendications, le premier laser (16) (i) fournissant une ligne continue sur la surface du premier substrat (10), ou (ii) fournissant une série de motifs discrets ayant un diamètre compris entre au moins environ 0,1 µm et au moins environ 10 µm et un espacement compris entre au moins environ 0,1 µm et au moins environ 10 µm, éventuellement le premier laser (16) définissant un motif circulaire, un motif carré, un motif hexagonal, un motif triangulaire, un motif ovale sur la surface du premier substrat (10).
